# EUROPEAN PATENT APPLICATION

(11) **EP 4 776 006 A1**
(43) Date of publication of application: **15.07.2026**
(21) Application number: 25867223.7
(22) Date of filing: 19.06.2025
(51) Int. Cl.: G01R 31/364, G01R 31/36, G01R 31/389, G01R 31/01, H01R 13/64

(54) **CONNECTOR FASTENING DEVICE FOR BATTERY PACK**

(30) Priority: 13.11.2024 KR 20240161157
(71) Applicant: LG ENERGY SOLUTION, LTD., Seoul 07335 (KR)
(72) Inventor: SHIM, Changyu, Daejeon 34122 (KR); PARK, Chiwon, Daejeon 34122 (KR)
(74) Representative: Plasseraud IP
(86) International application number: PCT/KR2025/008493
(87) International publication number: WO 2026/106005

(57) **Abstract**

A device for automatically coupling high-voltage (HV) and low-voltage (LV) connectors of a battery pack is provided. A connector coupling device for the battery pack includes a cylinder configured to move a connector toward a connector housing provided on the battery pack, an XY stage connected to the cylinder and configured to insert the connector into the connector housing, and a correction unit connected to the XY stage and configured to correct a position of the connector inserted into the connector housing.

## Description

### TECHNICAL FIELD

The present disclosure relates to a connector coupling device for a battery pack, and more particularly, to a device for automatically coupling a high-voltage connector and a low-voltage connector of a battery pack applicable to an electric vehicle to a battery pack.

### BACKGROUND

Electric vehicles may be equipped with a battery pack to supply power to a drive motor. The battery pack includes a plurality of battery modules and a pack case that surrounds the battery modules, and each battery module may include a plurality of battery cells.

The battery pack is mainly mounted on a lower side of a vehicle body of the electric vehicle, and is provided with a high-voltage connector (HV CNT) and a low-voltage connector (LV CNT), so that the power inside the battery pack can be supplied to the outside or the internal battery cells can be charged using external power.

The high-voltage connector is a high-voltage connection and may be an electrical connection device used in a system that requires a high-voltage power source such as an electric motor of an electric vehicle. The high-voltage connector has excellent insulating and heat-resistant properties to ensure safe and reliable high-voltage transmission, enabling high-voltage power transmission between components within the system.

The low-voltage connector is a low-voltage connection and may be used to transmit low-voltage signals. The low-voltage connector may be used, in conjunction with the high-voltage connector, in areas of the system where various low-voltage signal connections are required, and may serve to safely connect low-level voltages, such as those used for power control and data signals. The low-voltage connector may be used primarily to connect components that require low-voltage power, such as a sensor and a control circuit.

The high-voltage connector and the low-voltage connector are key components for electrical connection and power transmission in a battery pack of an electric vehicle. The high-voltage connector and the low-voltage connector may enable safe and efficient power and signal connections between a battery and other major components.

In order to connect the high-voltage connector and the low-voltage connector to the battery pack, the worker manually connects the high-voltage connector and the low-voltage connector to the battery pack, which may lead to errors due to worker mistakes and an overall decrease in productivity.

In addition, the manual connection process between the high-voltage connector and low-voltage connector and the battery pack may increase labor costs and make it difficult to maintain work consistency. Accordingly, there is a need for the development of an automated device for accurately and efficiently connecting a high-voltage connector and a low-voltage connectors to a battery pack.

### SUMMARY

### [Technical Problem]

An object of the present disclosure is to secure automatic connection technology between a battery pack and a high-voltage connector and a low-voltage connector and to increase the mass production productivity of a battery pack by developing a device for automatically coupling a high-voltage connector and a low-voltage connector in a battery pack mass production line.

### [Technical Solution]

A connector coupling device for a battery pack configured to couple a connector to a battery pack according to the present disclosure may include a cylinder configured to move the connector toward a connector housing provided on the battery pack, an XY stage connected to the cylinder and configured to insert the connector into the connector housing, and a correction unit connected to the XY stage and configured to correct a position of the connector inserted into the connector housing.

In addition, the connector coupling device for a battery pack may be configured to automatically couple the connector to the battery pack.

In addition, the XY stage may be configured to move the connector in an X direction or a Y direction so that the connector is aligned with a connector coupling portion provided in the connector housing.

In addition, the correction unit may be configured to adjust a deviation in the position of the connector along the X direction, the Y direction, or a Z direction so that the connector is coupled to the connector coupling portion.

In addition, the correction unit may be configured to adjust errors in a coupling position and an angle between the connector housing and the connector by tilting or rotating the connector.

In addition, the correction unit may include a plurality of correction units configured to correspond to a stiffness of the connector or a pressure level of the cylinder.

In addition, the cylinder may include a single-stroke cylinder configured as a single-acting type using pneumatic or hydraulic pressure.

In addition, the XY stage may be disposed between the cylinder and the correction unit.

In addition, the correction unit may be disposed between the XY stage and the connector.

In addition, the connector coupling device for a battery pack may further include a mount configured to mount the battery pack.

In addition, the connector may include a high-voltage connector and a low-voltage connector, and the connector coupling device for a battery pack may further include a high-voltage connector unit configured to couple the high-voltage connector to the battery pack, and a low-voltage connector unit configured to couple the low-voltage connector to the battery pack.

In addition, the connector coupling device for a battery pack may be configured to automatically and simultaneously couple the high-voltage connector and the low-voltage connector to the battery pack.

In addition, the high-voltage connector unit may include a high-voltage cylinder configured to move the high-voltage connector toward a high-voltage connector housing provided on the battery pack, a high-voltage XY stage connected to the high-voltage cylinder and configured to insert the high-voltage connector into the high-voltage connector housing, and a high-voltage correction unit connected to the high-voltage XY stage and configured to correct a position deviation of the high-voltage connector inserted into the high-voltage connector housing.

In addition, the low-voltage connector unit may include a low-voltage cylinder configured to move the low-voltage connector toward a low-voltage connector housing provided on the battery pack, a low-voltage XY stage connected to the low-voltage cylinder and configured to insert the low-voltage connector into the low-voltage connector housing, and a low-voltage correction unit connected to the low-voltage XY stage and configured to correct a position deviation of the low-voltage connector inserted into the low-voltage connector housing.

In addition, the connector coupling device for a battery pack may further include an inspection unit configured to inspect a connection state between the connector inserted into the connector housing and the battery pack.

In addition, the inspection unit may include an inspection unit plus terminal connected to a battery plus terminal of the battery pack and a high-voltage connector minus terminal of the high-voltage connector, and an inspection unit minus terminal connected to a battery minus terminal of the battery pack and a high-voltage connector plus terminal of the high-voltage connector, and the inspection unit may be configured to check a connection state between the high-voltage connector and the battery pack by measuring resistance between the inspection unit plus terminal and the inspection unit minus terminal.

In addition, the inspection unit may include a plurality of inspection unit terminals connected to low-voltage connector pins of the low-voltage connector, which are connected to battery pins of the battery pack, and the inspection unit may be configured to check a connection state between the low-voltage connector and the battery pack by measuring resistance associated with each of the plurality of inspection unit terminals.

In addition, the high-voltage correction unit may be configured to prevent disconnection between the high-voltage connector inserted into the high-voltage connector housing and the battery pack due to a weight of a cable connected to the high-voltage connector.

### [Advantageous Effects]

The connector coupling device for a battery pack according to the present disclosure can maximize production work efficiency and prevent errors caused by manual coupling by automatically coupling a high-voltage connector and a low-voltage connector to a battery pack.

The connector coupling device for a battery pack according to the present disclosure includes a correction unit, which enables various types of connectors to be coupled to the battery pack so as to be compatible with the battery pack by adjusting the position and angle of the connector, thereby increasing the flexibility of the production line.

### BRIEF DESCRIPTION OF THE DRAWINGS

FIG. 1 is a diagram illustrating an electric vehicle equipped with a battery pack in an aspect of the present disclosure.
FIG. 2 is a diagram illustrating a battery pack in an aspect of the present disclosure.
FIG. 3 is a diagram illustrating a connector connected to a battery pack through a coupling device, in a connector coupling device for a battery pack according to an aspect of the present disclosure.
FIG. 4 is a diagram illustrating a high-voltage connector unit, in the connector coupling device for a battery pack according to an aspect of the present disclosure.
FIG. 5 is a diagram illustrating a low-voltage connector unit, in the connector coupling device for a battery pack according to an aspect of the present disclosure.
FIG. 6 is a diagram illustrating a battery pack including a connector housing, in the connector coupling device for a battery pack according to an aspect of the present disclosure.
FIG. 7 is a diagram illustrating a correction unit, in the connector coupling device for a battery pack according to an aspect of the present disclosure.
FIG. 8 is a diagram illustrating a tilted aspect of a high-voltage connector connected to the battery pack, in the connector coupling device for a battery pack according to an aspect of the present disclosure.
FIG. 9 is a circuit diagram of an inspection unit that inspects a connection state between the battery pack and a connector, in the connector coupling device for a battery pack according to an aspect of the present disclosure.

### DETAILED DESCRIPTION

Aspects described herein and configurations illustrated in the drawings are merely preferred examples of the disclosure, and various modified embodiments capable of substituting the aspects and the drawings of the present specification may exist at the time of filing the present application.

In addition, like reference numerals or symbols given in each drawing of the present specification represent components or elements that perform substantially the same functions. Additionally, the terms used herein are used to describe the embodiments and are not intended to restrict and/or limit the disclosure. The singular forms "a", "an" and "the" are intended to include plural forms as well, unless the context clearly indicates otherwise.

The terms such as "comprise", "include" or "have" used herein are to designate that a characteristic, a number, a step, an operation, an element, a part, or combinations thereof described herein exist, and do not preclude in advance the possibility of the presence or addition of one or more other characteristics, numbers, steps, operations, elements, parts, or combinations thereof.

In addition, the terms including ordinals such as "first," "second," and the like used herein may be used to describe various elements, but the elements are not limited by the terms, and the terms are used to only distinguish one element from another element.

Note that the terms "front," "rear," "upper," and "lower" used in the description below are defined based on the drawings, and the shape and location of each element are not limited by these terms.

Hereinafter, aspects of the present disclosure will be described in detail with reference to the attached drawings.

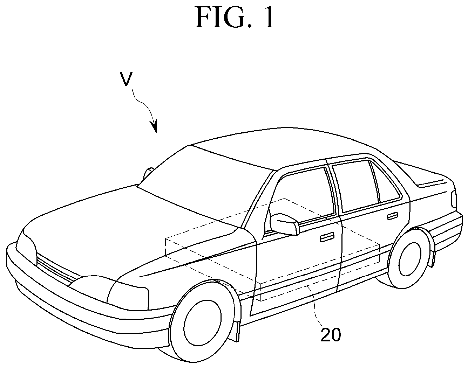

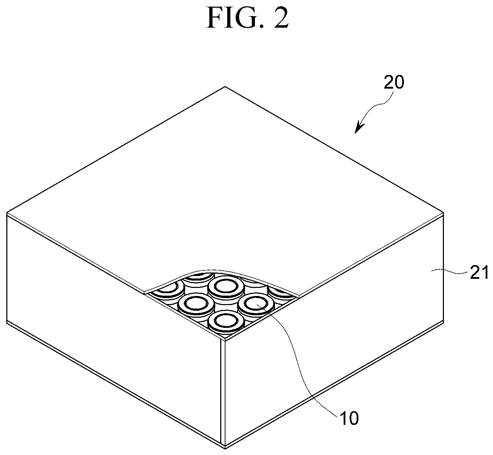

FIG. 1 is a diagram illustrating an electric vehicle equipped with a battery pack in an aspect of the present disclosure. FIG. 2 is a diagram illustrating a battery pack in an aspect of the present disclosure.

Referring to FIGS. 1 and 2, a plurality of battery cells 10 may be accommodated in a pack case 21 to form a battery pack 20. The plurality of battery cells 10 may constitute a battery module.

The plurality of battery cells 10 may include a plurality of cylindrical battery cells 10. However, no such limitation is intended. That is, the plurality of battery cells 10 included in the battery pack 20 according to an aspect of the present disclosure may include a cylindrical type, a prismatic shape, a pouch type, or the like.

The battery pack 20 may further include various control and protection systems such as a battery management system (BMS).

The battery pack 20 may be applied to various devices. Specifically, the battery pack may be applied to transportation means such as electric bicycles, electric vehicles, and hybrid vehicles, as well as ESS (Energy Storage System). However, no such limitation is intended, and the battery pack may be applied to various devices that can use secondary batteries.

Wheels of an electric vehicle V may be driven by an electric motor that receives power from the battery pack 20, thereby driving the electric vehicle.

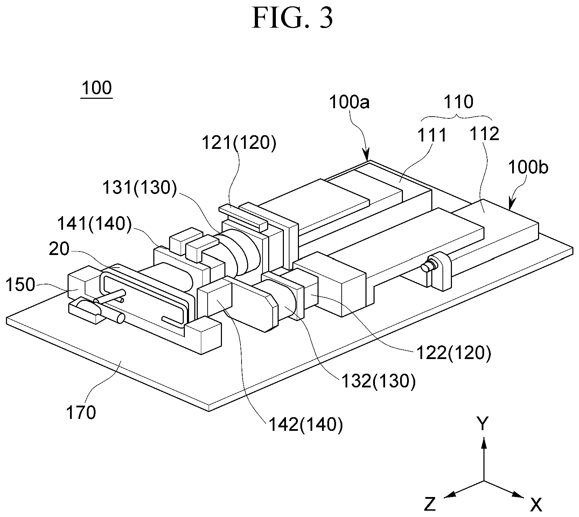

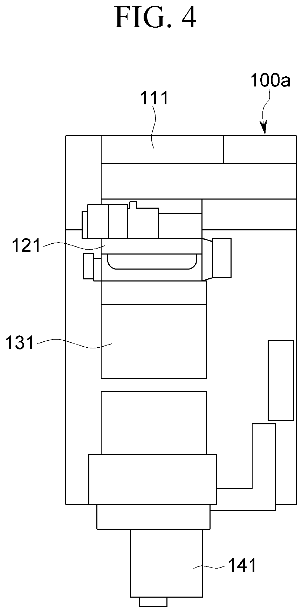

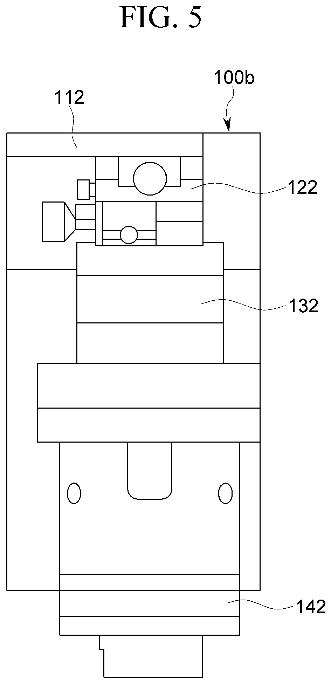

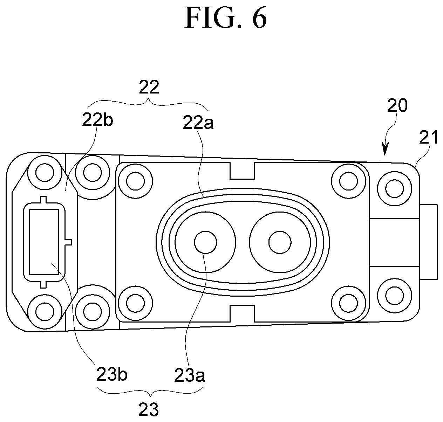

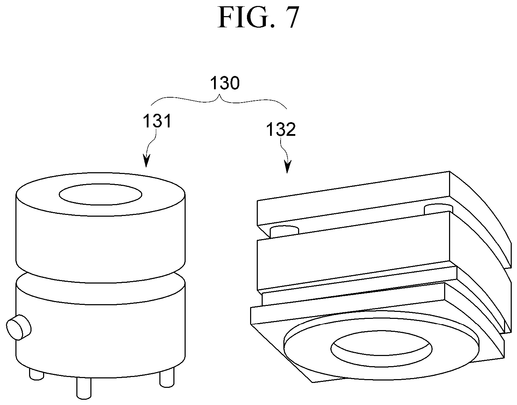

FIG. 3 is a diagram illustrating a connector connected to a battery pack through a coupling device, in a connector coupling device for a battery pack according to an aspect of the present disclosure. FIG. 4 is a diagram illustrating a high-voltage connector unit, in the connector coupling device for a battery pack according to an aspect of the present disclosure. FIG. 5 is a diagram illustrating a low-voltage connector unit, in the connector coupling device for a battery pack according to an aspect of the present disclosure. FIG. 6 is a diagram illustrating a battery pack including a connector housing, in the connector coupling device for a battery pack according to an aspect of the present disclosure. FIG. 7 is a diagram illustrating a correction unit, in the connector coupling device for a battery pack according to an aspect of the present disclosure.

Referring to FIGS. 3 to 7, a connector coupling device 100 for a battery pack according to an aspect of the present disclosure may be configured to automatically couple a connector 140 to the battery pack 20. The connector 140 may be automatically moved toward a connector housing 22 provided on the battery pack 20 by the connector coupling device 100 for a battery pack, and the connector 140 may be automatically coupled to a connector coupling portion 23 provided in the connector housing 22.

The battery pack 20 may include the connector housing 22 into which the connector 140 is inserted, and the connector coupling portion 23 provided in the connector housing 22 to allow the connector 140 to be coupled. The shapes of the connector housing 22 and the connector coupling portion 23 are not limited, and may include various structures by which the connector 140 can be coupled to the battery pack 20. The connector coupling portion 23 may be provided in plurality.

The connector coupling device 100 for a battery pack according to an aspect of the present disclosure may include a cylinder 110 configured to move the connector 140 toward the connector housing 22 provided on the battery pack 20, and an XY stage 120 connected to the cylinder 110 and configured to insert the connector 140 into the connector housing 22.

The cylinder 110 may be configured as a single-acting type. The cylinder 110 may include a single-stroke cylinder. The cylinder 110 may use pneumatic or hydraulic pressure. However, no such limitation is intended.

The single-acting type may be designed so that a piston of the cylinder 110 exerts force in only one direction. The single-acting cylinder 110 may perform an operation of pushing or pulling a piston using pneumatic or hydraulic pressure, and may include a structure in which the piston returns in an opposite direction by a spring or an external force. However, no such limitation is intended.

The cylinder 110 included in the connector coupling device 100 for a battery pack according to an aspect of the present disclosure may move the connector 140 toward the connector housing 22 so as to automatically couple the connector 140 to the battery pack 20, and may apply a force to press the connector 140 in the Z-axis direction so as to couple the connector 140 with the connector coupling portion 23 provided in the connector housing 22.

That is, the connector coupling device 100 for a battery pack according to an aspect of the present disclosure may adjust a position or angle of the connector 140 through the XY stage 120 and a correction unit 130, but ultimately, the power to couple the connector 140 to the battery pack 20 may be provided by the cylinder 110.

The cylinder 110 of the connector coupling device 100 for a battery pack according to an aspect of the present disclosure adopts a single-acting type, and thus has a structurally simple configuration, which may facilitate maintenance, eliminate the need for additional complex feedback mechanisms, and reduce costs for manufacturing and maintenance.

The cylinder 110 according to an aspect of the present disclosure may include a servo cylinder. The servo cylinder may be a device combining a servo motor and a cylinder. The servo cylinder may precisely control position and force, may be particularly useful in situations where automatic control is required, and unlike typical pneumatic or hydraulic cylinders, may precisely control position, speed, force, and the like. However, no such limitation is intended.

The servo cylinder may precisely control a piston inside the cylinder by converting rotary motion of the servo motor into linear motion. Therefore, the servo cylinder may move at high speed while maintaining precision at each position, making it suitable for automated machines.

The XY stage 120 included in the connector coupling device 100 for a battery pack according to an aspect of the present disclosure may perform positioning and alignment of the connector 140 together with the cylinder 110 so that the connector 140 is accurately located in the connector housing 22 provided on the battery pack 20.

That is, the XY stage 120 may accurately align the connector 140 to a coupling position with the connector coupling portion 23 provided on the battery pack 20. With this, errors that may occur during the coupling process of the connector 140 and the battery pack 20 can be reduced, the connector 140 can be coupled to the battery pack 20 at an accurate location, and the coupling quality can be improved.

Accordingly, the XY stage 120 may control two-dimensional movement of the connector 140 in the X direction and the Y direction, and may precisely control the position of the connector 140 with an accuracy of a micrometer (µm) or less.

The XY stage 120 may be used as part of an automated system, and may perform various tasks repeatedly and accurately. Accordingly, the automatic coupling between the connector 140 and the battery pack 20 can be accurately performed without errors.

The XY stage 120 may be disposed between the cylinder 110 and the correction unit 130. The cylinder 110 may be connected to one side of the XY stage 120, and the correction unit 130 may be connected to the other side of the XY stage 120. However, no such limitation is intended.

The XY stage 120 may be configured to move the connector 140 in the X direction or the Y direction so that the connector 140 is aligned with the connector coupling portion 23 provided in the connector housing 22.

The connector coupling device 100 for a battery pack according to an aspect of the present disclosure may include the correction unit 130 connected to the XY stage 120 and configured to correct a position deviation of the connector 140 inserted into the connector housing 22.

The correction unit 130 may be used in an automated system or machine device to ensure accuracy and to correct a position or deviation. The correction unit 130 according to an aspect of the present disclosure may ensure a stable and accurate connection by inserting the connector 140 into a correct position of the connector coupling portion 23 and correcting any position deviation or inclination that may occur during the coupling process between the connector 140 and the battery pack 20.

The correction unit 130 may adjust the position and angle in the X, Y, or Z direction to correct the connector 140 so that the connector is inserted into the correct position of the connector coupling portion 23. The correction unit 130 may automatically detect and correct small physical tolerances that may be set during design between the connector 140 and the battery pack 20.

The correction unit 130 may be configured to adjust a deviation in the position of the connector 140 along the X direction, the Y direction, or the Z direction so that the connector 140 is coupled to the connector coupling portion 23.

The correction unit 130 may be configured to adjust errors in a coupling position and an angle between the connector housing 22 and the connector 140 by tilting or rotating the connector 140. The correction unit 130 may be configured to correct clearance or tolerance between the connector housing 22 and the connector 140.

The correction unit 130 may be configured to correct distances between a plurality of connector coupling portions 23 provided inside the connector housing 22 and tolerances between the plurality of connector coupling portions 23 and the connector 140.

The correction unit 130 may include a tilting structure capable of tilting the connector 140 to achieve an appropriate angle of the connector 140. The correction unit 130 may improve a success rate of coupling by correcting a slight height difference or an angle error that may occur during the coupling process between the connector 140 and the battery pack 20 through the tilting structure.

The correction unit 130 may contribute to the automated coupling process between the connector 140 and the battery pack 20, and may improve the consistency and efficiency of the operation by allowing the position and angle of the connector 140 to be precisely adjusted without manual intervention in an automated system.

The correction unit 130 may include a plurality of correction units 130 configured to correspond to the stiffness of the connector 140 or the pressure level of the cylinder 110. The size or shape of the connector 140 coupled to the battery pack 20 may vary, and the correction unit 130 may include a plurality of correction units 130 designed to correspond to a plurality of connector 140 models having various characteristics.

The correction unit 130 may be disposed between the XY stage 120 and the connector 140. The XY stage 120 may be connected to one side of the correction unit 130, and the connector 140 may be connected to the other side of the correction unit 130. However, no such limitation is intended.

The connector coupling device 100 for a battery pack according to an aspect of the present disclosure may include a mount 150 configured to mount the battery pack 20 and a plate 170 provided to support the cylinder 110.

The mount 150 may be configured such that the battery pack 20 can be placed thereon. The mount 150 may include a "U" shape having a groove in which the battery pack 20 is placed. However, no such limitation is intended. For example, the mount 150 may have various shapes and structures as long as the battery pack 20 can be placed thereon and connected to the connector 140 by the connector coupling device 100 for a battery pack according to an aspect of the present disclosure.

On the plate 170, components of the connector coupling device 100 for a battery pack according to an aspect of the present disclosure may be arranged. The cylinder 110 and the mount 150 may be arranged on the plate 170. The cylinder 110 and the mount 150 may be fixed to the plate 170 or detachably connected to the plate 170.

When the cylinder 110 and the mount 150 are fixedly coupled to the plate 170, the coupling error between the connector 140 and the battery pack 20 can be reduced, and the operation efficiency can be improved.

A process of driving the connector coupling device 100 for a battery pack according to an aspect of the present disclosure will be described below in detail.

The connector coupling device 100 for a battery pack according to an aspect of the present disclosure may be configured to automatically couple the connector 140 to the battery pack 20. To this end, the cylinder 110 may insert the connector 140 into the connector housing 22 provided on the battery pack 20.

After the connector 140 is inserted into the connector housing 22, the XY stage 120 may adjust the position of the connector 140 in the X or Y direction so as to couple the connector 140 to the connector coupling portion 23.

That is, the cylinder 110 and the XY stage 120 may adjust the position of the connector 140 in the X or Y direction so that the connector 140 is coupled to the connector coupling portion 23 provided on the battery pack 20, and may couple the connector 140 to the battery pack 20 in the Z direction.

During the coupling process between the connector 140 and the connector coupling portion 23 by the cylinder 110 and the XY stage 120, deviations, tolerances, clearances, and the like in the X or Y direction between the connector 140 and the connector coupling portion 23 may be corrected by the correction unit 130.

The correction unit 130 may precisely couple the connector 140 to the connector coupling portion 23 through the tilting structure.

The connector coupling device 100 for a battery pack according to an aspect of the present disclosure can automatically couple the connector 140 to the battery pack 20 through the cylinder 110, the XY stage 120, and the correction unit 130.

The connector 140 of the connector coupling device 100 for a battery pack according to an aspect of the present disclosure may include a high-voltage connector 141 and a low-voltage connector 142.

The high-voltage connector 141 may be an electrical connection device used in a system that requires a high-voltage power source such as an electric motor of the electric vehicle (V, see FIG. 1). The low-voltage connector 142 may be used, in conjunction with the high-voltage connector, in areas of the system where various low-voltage signal connections are required, and may be mainly used to connect components that require low-voltage power, such as sensors and control circuits.

The high-voltage connector 141 and the low-voltage connector 142 are key components for electrical connection and power transmission in the battery pack 20 of the electric vehicle (V, see FIG. 1). The high-voltage connector 141 and the low-voltage connector 142 may enable safe and efficient power and signal connections between the battery pack 20 and other major components.

The connector coupling device 100 for a battery pack may include a high-voltage connector unit 100a configured to couple the high-voltage connector 141 to the battery pack 20, and a low-voltage connector unit 100b configured to couple the low-voltage connector 142 to the battery pack 20.

The high-voltage connector unit 100a may include a high-voltage cylinder 111 configured to move the high-voltage connector 141 toward a high-voltage connector housing 22a provided on the battery pack 20, and a high-voltage XY stage 121 connected to the high-voltage cylinder 111 and configured to insert the high-voltage connector 141 into the high-voltage connector housing 22a.

The high-voltage cylinder 111 included in the high-voltage connector unit 100a according to an aspect of the present disclosure may move the high-voltage connector 141 toward the high-voltage connector housing 22a so as to automatically couple the high-voltage connector 141 to the battery pack 20, and may apply a force to press the high-voltage connector 141 in the Z-axis direction so as to couple the high-voltage connector 141 to a high-voltage connector coupling portion 23a provided in the high-voltage connector housing 22a.

The high-voltage cylinder 111 may include an MXQ25-50AS cylinder. However, no such limitation is intended.

The high-voltage XY stage 121 included in the high-voltage connector unit 100a according to an aspect of the present disclosure may perform positioning and alignment of the high-voltage connector 141 together with the high-voltage cylinder 111 so that the high-voltage connector 141 is accurately located in the high-voltage connector housing 22a provided on the battery pack 20. That is, the high-voltage XY stage 121 may accurately align the high-voltage connector 141 to a coupling position with the high-voltage connector coupling portion 23a provided on the battery pack 20.

The high-voltage XY stage 121 may be disposed between the high-voltage cylinder 111 and a high-voltage correction unit 131. However, no such limitation is intended.

The high-voltage XY stage 121 may be configured to move the high-voltage connector 141 in the X direction or the Y direction so that the high-voltage connector 141 is aligned with the high-voltage connector coupling portion 23a provided in the high-voltage connector housing 22a.

The high-voltage XY stage 121 may include an XYSGB60 XY stage. However, no such limitation is intended.

The high-voltage connector unit 100a according to an aspect of the present disclosure may include the high-voltage correction unit 131 connected to the high-voltage XY stage 121 and configured to correct a position deviation of the high-voltage connector 141 inserted into the high-voltage connector housing 22a.

The high-voltage correction unit 131 may ensure a stable and accurate connection by inserting the high-voltage connector 141 into a correct position of the high-voltage connector coupling portion 23a and correcting any position deviation or inclination that may occur during the coupling process between the high-voltage connector 141 and the battery pack 20.

The high-voltage correction unit 131 may adjust the position and angle in the X, Y, or Z direction to correct the high-voltage connector 141 so that the high-voltage connector is inserted into the correct position of the high-voltage connector coupling portion 23a.

The high-voltage correction unit 131 may be configured to adjust errors in a coupling position and an angle between the high-voltage connector housing 22a and the high-voltage connector 141 by tilting or rotating the high-voltage connector 141. The high-voltage correction unit 131 may be configured to correct clearance or tolerance between the high-voltage connector housing 22a and the high-voltage connector 141.

The high-voltage correction unit 131 may include a tilting structure capable of tilting the high-voltage connector 141 to achieve an appropriate angle of the high-voltage connector 141.

The high-voltage correction unit 131 may include a plurality of high-voltage correction units 131 configured to correspond to the stiffness of the high-voltage connector 141 or the pressure level of the high-voltage cylinder 111.

The high-voltage correction unit 131 may be disposed between the high-voltage XY stage 121 and the high-voltage connector 141. However, no such limitation is intended.

The high-voltage correction unit 131 may include an AGE-U-050 correction unit configured to finely adjust a position deviation of the high-voltage connector 141 along the X, Y, or Z direction so that the high-voltage connector 141 is precisely and automatically inserted into the high-voltage connector housing 22a. However, no such limitation is intended.

The low-voltage connector unit 100b according to an aspect of the present disclosure may include a low-voltage cylinder 112 configured to move the low-voltage connector 142 toward a low-voltage connector housing 22b provided on the battery pack 20, and a low-voltage XY stage 122 connected to the low-voltage cylinder 112 and configured to insert the low-voltage connector 142 into the low-voltage connector housing 22b.

The low-voltage cylinder 112 may move the low-voltage connector 142 toward the low-voltage connector housing 22b so as to automatically couple the low-voltage connector 142 to the battery pack 20, and may apply a force to press the low-voltage connector 142 in the Z-axis direction so as to couple the low-voltage connector 142 to a low-voltage connector coupling portion 23b provided in the low-voltage connector housing 22b.

The low-voltage cylinder 112 may include an MXQ25L-75AS cylinder. However, no such limitation is intended.

The low-voltage XY stage 122 included in the low-voltage connector unit 100b according to an aspect of the present disclosure may perform positioning and alignment of the low-voltage connector 142 together with the low-voltage cylinder 112 so that the low-voltage connector 142 is accurately located in the low-voltage connector housing 22b provided on the battery pack 20. That is, the low-voltage XY stage 122 may accurately align the low-voltage connector 142 to a coupling position with the low-voltage connector coupling portion 23b provided on the battery pack 20.

The low-voltage XY stage 122 may be disposed between the low-voltage cylinder 112 and a low-voltage correction unit 132. However, no such limitation is intended.

The low-voltage XY stage 122 may be configured to move the low-voltage connector 142 in the X direction or the Y direction so that the low-voltage connector 142 is aligned with the low-voltage connector coupling portion 23b provided in the low-voltage connector housing 22b.

The low-voltage XY stage 122 may include a DSXYEG40 XY stage. However, no such limitation is intended.

The low-voltage connector unit 100b according to an aspect of the present disclosure may include the low-voltage correction unit 132 connected to the low-voltage XY stage 122 and configured to correct a position deviation of the low-voltage connector 142 inserted into the low-voltage connector housing 22b.

The low-voltage correction unit 132 may ensure a stable and accurate connection by inserting the low-voltage connector 142 into a correct position of the low-voltage connector coupling portion 23b and correcting any position deviation or inclination that may occur during the coupling process between the low-voltage connector 142 and the battery pack 20.

The low-voltage correction unit 132 may adjust the position and angle in the X, Y, or Z direction to correct the low-voltage connector 142 so that the low-voltage connector is inserted into the correct position of the low-voltage connector coupling portion 23b.

The low-voltage correction unit 132 may be configured to adjust errors in a coupling position and an angle between the low-voltage connector housing 22b and the low-voltage connector 142 by tilting or rotating the low-voltage connector 142. The low-voltage correction unit 132 may be configured to correct clearance or tolerance between the low-voltage connector housing 22b and the low-voltage connector 142.

The low-voltage correction unit 132 may include a tilting structure capable of tilting the low-voltage connector 142 to achieve an appropriate angle of the low-voltage connector 142.

The low-voltage correction unit 132 may include a plurality of low-voltage correction units 132 configured to correspond to the stiffness of the low-voltage connector 142 or the pressure level of the low-voltage cylinder 112.

The low-voltage correction unit 132 may be disposed between the low-voltage XY stage 122 and the low-voltage connector 142. However, no such limitation is intended.

The low-voltage correction unit 132 may include an AGE-F-XY-040-3 correction unit configured to finely adjust a position deviation of the low-voltage connector 142 along the X, Y, or Z direction so that the low-voltage connector 142 is precisely and automatically inserted into the low-voltage connector housing 22b. However, no such limitation is intended.

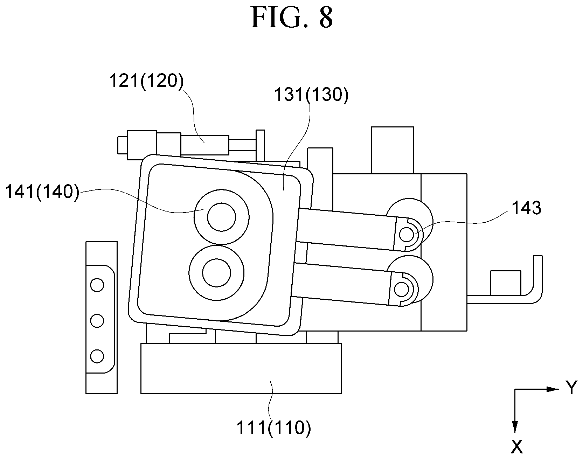

FIG. 8 is a diagram illustrating a tilted aspect of the high-voltage connector connected to the battery pack, in the connector coupling device for a battery pack according to an aspect of the present disclosure. Referring to FIG. 8, the high-voltage correction unit 131 may be configured to prevent the disconnection between the high-voltage connector 141 inserted into the high-voltage connector housing 22a and the battery pack 20 due to a weight of a cable 143 connected to the high-voltage connector 141.

The high-voltage connector 141 is a component connected to the battery pack (20, see FIG. 3), and the cable 143 connected to the high-voltage connector 141 may be quite heavy and thick because it must safely transmit high-voltage power. Due to this, a problem may occur in which the high-voltage connector 141 is tilted due to the weight of the cable 143 after being coupled to the battery pack (20, see FIG. 3). The high-voltage connector 141 may be tilted along the X direction due to the weight of the cable 143 connected to the high-voltage connector 141.

To prevent the high-voltage connector 141 from being tilting over time due to the weight of the cable 143 connected to the high-voltage connector 141, the high-voltage correction unit 131 may stabilize the position of the high-voltage connector 141 and continuously maintain balance even after the high-voltage connector 141 is coupled to the battery pack (20, see FIG. 3).

The high-voltage connector 141 may include a material configured to prevent the disconnection between the high-voltage connector 141 inserted into the high-voltage connector housing 22a and the battery pack (20, see FIG. 3) due to the weight of the cable 143 connected to the high-voltage connector 141. However, no such limitation is intended.

For example, the weight of the high-voltage connector 141 may be reduced by applying a high-strength and lightweight material (an aluminum alloy, a polymer material, or the like) to the exterior and internal components of the high-voltage connector 141.

Alternatively, by improving the coupling form of the high-voltage connector 141 that is coupled to the high-voltage connector coupling portion (23a, see FIG. 6) provided on the battery pack (20, see FIG. 3), the coupling area can be increased so that the high-voltage connector 141 is inserted more deeply and coupled when coupled to the high-voltage connector coupling portion (23a, see FIG. 6).

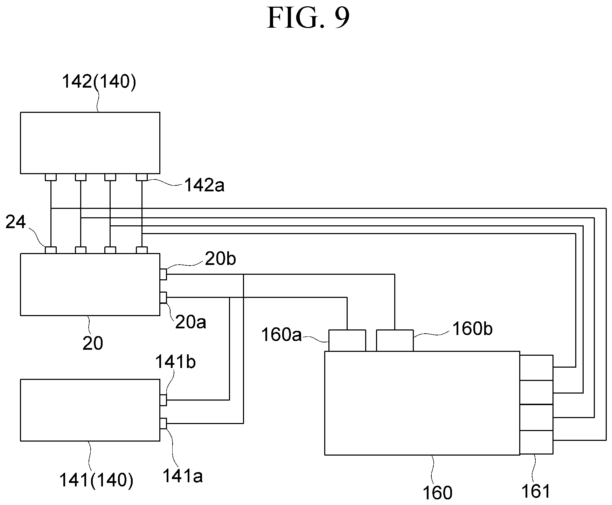

FIG. 9 is a circuit diagram of an inspection unit that inspects a connection state between the battery pack and the connector, in the connector coupling device for a battery pack according to an aspect of the present disclosure. Referring to FIG. 9, the connector coupling device (100, see FIG. 3) for a battery pack according to an aspect of the present disclosure may include an inspection unit 160 configured to inspect a connection state the connector 140 inserted into the connector housing (22, see FIG. 6) and the battery pack 20.

The inspection unit 160 may measure the coupling state between the connector 140 and the battery pack 20 using a digital multimeter (DMM), and may verify an electrical connection state between the connector 140 and the battery pack 20.

The inspection unit 160 may measure a resistance value of each of the high-voltage connector 141 and the low-voltage connector 142 to determine a coupling accuracy between the high-voltage connector 141 or the low-voltage connector 142 and the battery pack 20.

The inspection unit 160 including the DMM may automatically evaluate the electrical connection state between the connector 140 and the battery pack 20 after the connector 140 and the battery pack 20 are automatically coupled by the connector coupling device (100, see FIG. 3) for a battery pack according to an aspect of the present disclosure.

If the resistance value measured by the inspection unit 160 is too high or infinite, it may indicate that the connection between the connector 140 and the battery pack 20 is not properly made or that there is poor contact.

Additionally, the inspection unit 160 may inspect whether the connection between the connector 140 and the battery pack 20 is maintained without any disconnection. The coupling quality can be ensured by evaluating, through continuity testing by the inspection unit 160, whether a complete circuit is formed between the connector 140 and the battery pack 20 without disconnection.

Note that the accuracy of the inspection unit 160 that inspects the electrical connection between the connector 140 and the battery pack 20 can be determined from the precise automatic coupling process between the connector 140 and the battery pack 20 performed by the connector coupling device (100, see FIG. 3) for a battery pack according to an aspect of the present disclosure.

The inspection unit 160 may include an inspection unit plus terminal 160a connected to a battery plus terminal 20a of the battery pack 20 and a high-voltage connector minus terminal 141b of the high-voltage connector 141, and an inspection unit minus terminal 160b connected to a battery minus terminal 20b of the battery pack 20 and a high-voltage connector plus terminal 141a of the high-voltage connector 141.

The inspection unit 160 may be configured to check a connection state between the high-voltage connector 141 and the battery pack 20 by measuring resistance between the inspection unit plus terminal 160a and the inspection unit minus terminal 160b.

The inspection unit 160 according to an aspect of the present disclosure may include a plurality of inspection unit terminals 161 connected to low-voltage connector pins 142a of the low-voltage connector 142, which are connected to battery pins 24 of the battery pack 20.

The inspection unit 160 may be configured to check a connection state between the low-voltage connector 142 and the battery pack 20 by measuring resistance associated with each of the plurality of inspection unit terminals 161.

Although the technical idea of the present disclosure has been described above through the specific aspects, the scope of the present disclosure is not limited to these aspects.

It should be understood that various modifications and variations can be made by one skilled in the art without departing from the spirit and scope of the present disclosure as recited in the claims, and such modifications and variations are intended to fall within the scope of the present disclosure.

## Claims

1. A connector coupling device for a battery pack configured to couple a connector to a battery pack, the connector coupling device for a battery pack comprising:
a cylinder configured to move the connector toward a connector housing provided on the battery pack;
an XY stage connected to the cylinder and configured to insert the connector into the connector housing; and
a correction unit connected to the XY stage and configured to correct a position of the connector being inserted into the connector housing.

2. The connector coupling device for a battery pack of claim 1, wherein the connector coupling device for a battery pack is configured to automatically couple the connector to the battery pack.

3. The connector coupling device for a battery pack of claim 1, wherein the XY stage is configured to move the connector in an X direction or a Y direction to align the connector with a connector coupling portion provided in the connector housing.

4. The connector coupling device for a battery pack of claim 3, wherein the correction unit is configured to adjust a deviation in the position of the connector along the X direction, the Y direction, or a Z direction so that the connector couples to the connector coupling portion.

5. The connector coupling device for a battery pack of claim 1, wherein the correction unit is configured to tilt or rotate the connector to adjust errors in a coupling position or an angle between the connector housing and the connector.

6. The connector coupling device for a battery pack of claim 1, wherein the correction unit is one of a plurality of correction units configured to correspond to a stiffness of the connector or a pressure level of the cylinder.

7. The connector coupling device for a battery pack of claim 1, wherein the cylinder comprises a single-stroke cylinder configured to use pneumatic or hydraulic pressure.

8. The connector coupling device for a battery pack of claim 1, wherein the XY stage is disposed between the cylinder and the correction unit.

9. The connector coupling device for a battery pack of claim 1, wherein the correction unit is disposed between the XY stage and the connector.

10. The connector coupling device for a battery pack of claim 1, further comprising a mount configured to mount the battery pack.

11. The connector coupling device for a battery pack of claim 1, wherein
the connector includes a high-voltage connector and a low-voltage connector, and
the connector coupling device for a battery pack further comprises:
a high-voltage connector unit configured to couple the high-voltage connector to the battery pack, and
a low-voltage connector unit configured to couple the low-voltage connector to the battery pack.

12. The connector coupling device for a battery pack of claim 11, wherein the connector coupling device for a battery pack is configured to automatically and simultaneously couple the high-voltage connector and the low-voltage connector to the battery pack.

13. The connector coupling device for a battery pack of claim 11, wherein, in the high-voltage connector unit,
the cylinder is a high-voltage cylinder configured to move the high-voltage connector toward a high-voltage connector housing provided on the battery pack,
the XY stage is a high-voltage XY stage connected to the high-voltage cylinder and configured to insert the high-voltage connector into the high-voltage connector housing, and
the correction unit is a high-voltage correction unit connected to the high-voltage XY stage and configured to correct a position deviation of the high-voltage connector inserted into the high-voltage connector housing.

14. The connector coupling device for a battery pack of claim 11, wherein in the low-voltage connector unit,
the cylinder is a low-voltage cylinder configured to move the low-voltage connector toward a low-voltage connector housing provided on the battery pack,
the XY stage is a low-voltage XY stage connected to the low-voltage cylinder and configured to insert the low-voltage connector into the low-voltage connector housing, and
the correction unit is a low-voltage correction unit connected to the low-voltage XY stage and configured to correct a position deviation of the low-voltage connector inserted into the low-voltage connector housing.

15. The connector coupling device for a battery pack of claim 11, further comprising an inspection unit configured to inspect a connection state between the connector and the battery pack.

16. The connector coupling device for a battery pack of claim 15, wherein
the inspection unit includes
a positive terminal connected to a battery positive terminal of the battery pack and a high-voltage connector negative terminal of the high-voltage connector, and
a negative terminal connected to a battery negative terminal of the battery pack and a high-voltage connector positive terminal of the high-voltage connector, and
the inspection unit is configured to determine a connection state between the high-voltage connector and the battery pack by measuring resistance between the inspection unit positive terminal and the inspection unit negative terminal.

17. The connector coupling device for a battery pack of claim 15, wherein
the inspection unit includes a plurality of inspection unit terminals connected to low-voltage connector pins of the low-voltage connector, which are connected to battery pins of the battery pack, and
the inspection unit is configured to determine a connection state between the low-voltage connector and the battery pack by measuring resistance associated with each inspection unit terminal of the plurality of inspection unit terminals.

18. The connector coupling device for a battery pack of claim 13, wherein the high-voltage correction unit is configured to prevent disconnection between the high-voltage connector inserted into the high-voltage connector housing and the battery pack due to a weight of a cable connected to the high-voltage connector.
